# EUROPEAN PATENT APPLICATION

(11) **EP 4 325 624 A1**
(43) Date of publication of application: **21.02.2024**
(21) Application number: 22880097.5
(22) Date of filing: 19.09.2022
(51) Int. Cl.: H01M 10/42, H01M 10/44

(54) **CELL CHARGING/DISCHARGING TRAY, CELL AGING APPARATUS AND CELL AGING METHOD**

(30) Priority: 15.10.2021 CN 202111205764
(71) Applicant: Jiangsu Contemporary Amperex Technology Limited, Liyang, Jiangsu 213300 (CN)
(72) Inventor: HUANG, Caixia, hangzhou, Jiangsu 213300 (CN); HUANG, Dengfeng, hangzhou, Jiangsu 213300 (CN); TANG, Minghao, hangzhou, Jiangsu 213300 (CN)
(74) Representative: Rowlands, Stuart Michael
(86) International application number: PCT/CN2022/119684
(87) International publication number: WO 2023/061157

(57) **Abstract**

The present application relates to the technical field of lithium-ion batteries, and in particular to a cell charging/discharging tray, a cell aging apparatus, and a cell aging method. The tray comprises an insulating base component for accommodating various cells, and a conductive component for sequentially connecting an A-type cell and each B-type cell in parallel, wherein the conductive component is suitable for aging one A-type cell and several B-type cells at the same time, and the potential of the A-type cell is higher than the potential of each B-type cell. A design in which a base component is separated from a conductive component is applied to the tray in the present application, such that the aging of a high-potential cell is also completed when the aging of a low-potential cell has been completed, and the service life of the high-potential cell is not affected, and therefore the high-potential cell can be delivered after defective products are selected by means of self-discharging, which is conducive to improving the manufacturing efficiency. Compared with a manner in which a high-potential cell is fixed to charge a low-potential cell, the high-potential cell is prevented from being broken due to cyclic aging, which is conducive to reducing the manufacturing costs, and the tray in the present application is very simple, which is conducive to reducing the costs of a cell aging apparatus.

## Description

### CROSS REFERENCE TO RELATED APPLICATION

The present application claims priority to the Chinese Patent Application No. 202111205764.0, filed on Oct. 15, 2021 and entitled "Cell charging and discharging tray, cell ageing device and cell ageing device", the contents of which is incorporated in its entirety herein by reference.

### TECHNICAL FIELD

The present application relates to the technical field of lithium-ion batteries, and particularly relates to a cell charging and discharging tray, a cell ageing device and a cell ageing method.

### BACKGROUND

Self-discharge sorting is an ultimate goal of a cell ageing process, and cell self-discharge can be divided into physical self-discharge and chemical self-discharge according to different reaction types. In consideration of the impact of self-discharge on cells, self-discharge may be divided into two types: self-discharge in which the loss of capacity can be reversibly compensated and self-discharge in which the capacity is lost permanently.

Generally speaking, the energy loss caused by physical self-discharge is reversible, while the energy loss caused by chemical self-discharge is basically irreversible. The self-discharge of a cell is derived from two aspects: (1) self-discharge caused by a chemical system itself, which is mainly caused by side reactions inside the cell, specifically including changes of surface film layers of anode and cathode materials; potential changes caused by thermodynamic instability of electrodes; and the dissolution and precipitation of metal foreign matter impurities; (2) self-discharge of the cell caused by a micro-short circuit inside the cell caused by a separator, an anode and a cathode.

In some cases, ageing methods take a long time to test, are low in test accuracy, and are low in operation efficiency of the selection of unqualified products.

### SUMMARY

Other features and advantages of the present application will be described in the subsequent Specification, and in part will be apparent from the Specification, or may be learned through implementation of the present application. Objectives and other advantages of the present application will be achieved and attained by structures particularly pointed out in the Specification, Claims as well as other drawings.

The objective of the present application is to, for solving the above problems, provide a cell charging and discharging tray, a cell ageing device and a cell ageing method.

In a first aspect, the present application provides a cell charging and discharging tray adapted for simultaneously ageing a type-A cell and a plurality of type-B cells, a potential of the type-A cell being higher than that of each type-B cell; the tray includes an insulating base component for accommodating the type-A cell and the type-B cells, and a conductive component for realizing sequential parallel connection of the type-A cell and the type-B cells, where the base component is separated from the conductive component.

In some embodiments, the base component is a bottom plate extending upward along the periphery of a bottom surface to form side walls. The side walls are provided to prevent the cells from falling during handling.

In some embodiments, gripping portions are formed on two opposite side walls in a partially sunken manner; or, gripping portions are formed on the tops of the two opposite side walls along a surface parallel to a bottom surface of the bottom plate by means of extending in an opposite direction. The gripping portion is provided to facilitate the handling of the base component during an ageing process.

In some embodiments, the tray further includes a plurality of insulating separation components for separating the cells. The separation components are provided to prevent the occurrence of safety accidents caused by fire breaking out due to the collision of the cells.

In some embodiments, the separation components are a plurality of baffles separated from each other. The separation of the separation components (not connected to the base component) can improve the versatility of the cell charging and discharging tray.

In some embodiments, the baffles are arranged in parallel on the base component. When a spacing distance between the baffles matches the size of the cells, a poor contact between each probe and a positive/negative pole of a corresponding cell caused by shaking during handling can be avoided.

In some embodiments, the tray further includes a fastening component for encircling the cells to realize integrated fastening of the cells. The fastening component is provided to avoid a poor contact between each probe and a positive/negative pole of a corresponding cell caused by shaking during handling.

In some embodiments, the fastening component is a flexible belt-shaped hoop, and an opening-closing connection portion capable of being opened and closed is arranged at an opening of the hoop.

In some embodiments, the conductive component includes a first conductive component for realizing sequential connection of positive poles of the type-A cell and the type-B cells, and a second conductive component for realizing sequential connection of negative poles of the type-A cell and the type-B cells in the same order.

In some embodiments, the first conductive component includes a first metal strip and X probes arranged at intervals on a lower surface of the first metal strip; the second conductive component includes a second metal strip and Y probes arranged at intervals on a lower surface of the second metal strip; and both X and Y are natural numbers greater than or equal to 2.

In some embodiments, a spacing distance between the probes arranged on the first metal strip is equal to a spacing distance between the probes arranged on the second metal strip.

In some embodiments, a plurality of grooves with an internal thread are respectively provided at intervals on the lower surfaces of the first metal strip and the second metal strip, and an external thread for realizing threaded connection with the grooves are provided at an upper end of each of the probes.

In some embodiments, the number of the grooves with an internal thread arranged at intervals on the lower surface of the first metal strip is greater than X; the number of the grooves with an internal thread arranged at intervals on the lower surface of the second metal strip is greater than Y. This improvement is to realize that the cell charging and discharging tray is adapted for ageing cells of different size.

In some embodiments, X is equal to Y.

In some embodiments, the first conductive component includes a first main flexible conductive wire and X branch flexible conductive wires, where one end of each of the X branch flexible conductive wires is connected to the first main flexible conductive wire at intervals, and the other ends of the X branch flexible conductive wires are connected to a conductive clip; the second conductive component includes a second main flexible conductive wire and Y branch flexible conductive wires, where one end of each of the Y branch flexible conductive wires are connected to the second main flexible conductive wire at intervals, and the other ends of the Y branch flexible conductive wires are connected to a conductive clip; and both X and Y are natural numbers greater than or equal to 2.

In a second aspect, the present application provides a cell ageing device including a tray which is the cell charging and discharging tray in the above embodiment.

In a third aspect, the present application also provides a cell ageing method performing ageing by using the cell ageing device in the above embodiment, the cell ageing method including the following steps:
step 1: connecting positive poles of at least one type-A cell in a first state and at least one type-B cell in a second state through a first conductive component in sequence, and connecting negative poles thereof through a second conductive component in sequence, where a potential of the type-A cell is higher than that of each of the type-B cells;
step 2: performing standing on the connected cells at a first set temperature T1 for a first duration 11;
step 3: cooling each cell at a second set temperature T2, wherein T1 is greater than T2;
step 4: testing a voltage OCV1 of each cell;
step 5: performing standing on the cells at the second set temperature for a second duration t2;
step 6: testing a voltage OCV2 of each cell; and
step 7: based on the voltage OCV1 and the voltage OCV2, determining whether each cell is qualified according to a set rule.

In the technical solutions of embodiments of the present application, the type-A cell is configured to charge each of the type-B cells, so the potential of the type-A cell needs to be higher than that of each of the type-B cells. A cell with a highest working voltage greater than or equal to 4.05V is called a cell of a high-potential system, and may be used as the type-A cell of the present application; the cell may generally be a cell of a NCM system, and also may be a cell of a lithium cobalt oxide, ternary, or high nickel system or the like; and the potential of the type-A cell may be kept at greater than or equal to 3.85V after the type-A cell is charged until SOC is greater than or equal to 70%.

In some embodiments, the first state refers to a state of charge is greater than or equal to 70% and a holding potential is greater than or equal to 3.85V.

In some embodiments, the second state refers to a state of being fully charged with lithium.

In some embodiments, a maximum working voltage of each type-A cell is greater than or equal to 4.05V.

In some embodiments, the type-A cell is a cell of a NCM system, lithium cobaltate, a ternary system or a high-nickel system.

In some embodiments, each type-B cell is a cell of a LFP system.

In some embodiments, the first set temperature T1 is 25-80°C or 35-80°C.

In some embodiments, the second set temperature T2 is normal temperature.

In some embodiments, the first duration t1 is 0-7 days or 0-5 days.

In some embodiments, the second duration t2 is 12 hours to 30 days.

In some embodiments, the set rule is to calculate a voltage drop per unit time of each cell according to a formula K=(OCV2-OCV 1)/t2, then to convert the voltage drop per unit time into a K value specification according to monthly self-discharge requirements, and to determine that a cell having a voltage drop greater than the K value specification is unqualified and a cell having a voltage drop less than or equal to the K value specification is qualified.

In some embodiments, before step 1, the type-A cell and the type-B cells are sequentially placed on the base component, or, the type-A cell and all kinds of cells are arranged in a sequence first and then encircled by the fastening component to achieve integrated fastening of the cells.

In some embodiments, the base component and the fastening component have insulating properties.

In some embodiments, before step 1, a step of placing separation components between the cells is added.

In some embodiments, before or after step 3, the first conductive component and the second conductive component are removed.

By adopting above-mentioned technical solutions, the beneficial effects of the present application are as follows:
(1) the base component and the conductive component of the cell charging and discharging tray are designed separately, so that the ageing of the high-potential cell is completed after each low-potential cell is aged, and the service life of the high-potential cell is not affected, thus, shipment may be performed after self-discharge for selecting bad products is completed, which is conducive to improving the manufacturing efficiency;
(2) compared with a mode of fixing a high-potential cell to charge low-potential cells, the damage of the high-potential cell due to cyclic ageing is avoided, which is conducive to reducing the cost of manufacturing;
(3) the cell charging and discharging tray of the present application has a simple structure, which is conducive to reducing the cost of the cell ageing device; and
(4) when a cell is aged, if the cell has a low potential and an unstable voltage, the purposes of effectively performing high-temperature and high-potential dechemical self-discharge and metal precipitation acceleration cannot be achieved. Therefore, in the above method, a high-potential cell is connected in parallel with low-potential cells, so that the high-potential cell continuously charges the low-potential cells, in such a way that the potential of the low-potential cell is raised and the voltage is stable, thus, the purposes of effectively performing high-temperature and high-potential dechemical self-discharge and metal precipitation acceleration can be achieved.

It is to be understood that both the foregoing general description and the following detailed description are exemplary and explanatory only, and are not intended to limit the present disclosure.

It will be apparent that these and other objectives of the present application will become more apparent after details of preferred embodiments described with reference to various drawings and figures are explained below.

To make the above and other objectives, features and advantages of the present application more comprehensible, one or a plurality of preferred embodiments will be illustrated in detail below together with the drawings.

### BRIEF DESCRIPTION OF THE DRAWINGS

The drawings are used to provide a further understanding of the present application, and to constitute a part of the Specification, the drawings are used together with the embodiments of the present application to explain the present application, and do not constitute a limitation to the present application.

In the drawings, same reference numerals refer to same components, and the drawings are schematic and not necessarily to actual scale.

To illustrate the technical solutions in embodiments of the present application or in the prior art more clearly, the following briefly introduces the drawings required for describing the embodiments or the prior art. Apparently, the drawings in the following description show merely one or some embodiments of the present application, and those of ordinary skill in the art may still derive other drawings from these drawings without creative efforts.
FIG. 1 is a structural schematic diagram of a cell charging and discharging tray according to the present application;
FIG. 2 is another structural schematic diagram of the cell charging and discharging tray according to the present application;
FIG. 3 is a partial structural schematic diagram of the cell charging and discharging tray according to the present application; and
FIG. 4 is a flow chart of a cell ageing method according to the present application.

In the drawings, the figures are not necessarily to actual scale.

Explanation of reference numerals: 1-base component; 11-bottom plate; 12-side wall; 13-gripping portion; 2-conductive component; 21-first conductive component; 211-first metal strip; 22-second conductive component; 221-second metal strip; 23-probe; 3-separation component; 31-baffle; 4-fastening component; 41-hoop; 411-an opening-closing connection portion; 5-type-A cell; 6-type-B cell.

### DETAILED DESCRIPTION OF THE EMBODIMENTS

Embodiments of the technical solutions of the present application will be described in detail below with reference to the drawings. The following embodiments are only used to illustrate the technical solutions of the present application more clearly, and therefore are only examples, rather than limiting the scope of protection of the present application.

Unless otherwise defined, all technical and scientific terms used herein have the same meaning as commonly understood by those of ordinary skill in the technical field of the present application; and the terms used herein in the Specification of the present application are for the purpose of describing the specific embodiments only, and are not intended to limit the present application; the terms "comprising" and "having" and any variations thereof in the Specification and Claims of the present application as well as the brief description of the drawings are intended to cover but not exclude other contents.

In the description of the embodiments of the present application, the technical terms such as "first" and "second" are only used to distinguish different objects, and cannot be interpreted as indicating or implying relative importance or implicitly indicating the number, specific order, or primary and secondary relation of the indicated technical features. In the description of the embodiments of the present application, "a plurality of' means two or more, unless expressly specified otherwise.

Reference herein to "embodiment" means that particular features, structures, or characteristics described in connection with the embodiments may be included in at least one embodiment of the present application. The phrase "embodiment" appearing in various places in the Specification is not necessarily all referring to the same embodiment, nor is it a separate or alternative embodiment that is mutually exclusive with other embodiments. It is explicitly and implicitly understood by those skilled in the art that the embodiments described herein may be combined with other embodiments.

In the description of the embodiments of the present application, the term "and/or" herein is only an association relation to describe associated objects, indicating that there can be three kinds of relations, for example, A and/or B, which may mean that A exists alone, A and B exist simultaneously, and B exists alone. In addition, the character "/" herein generally indicates that fore-and-aft related objects are in an "or" relation.

In the description of the embodiments of the present application, the term "a plurality of' refers to more than two (including two), similarly, "a plurality of sets" refers to more than two sets (including two sets), and "a plurality of pieces" refers to more than two pieces (including two pieces).

In the description of the embodiments of the present application, the orientation or positional relations indicated by the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. are orientation or positional relations shown based on the accompanying drawings, only for convenience of describing the present application and simplifying the description, rather than indicating or implying that the indicated device or element must have a particular orientation, and be constructed and operative in a particular orientation, and thus may not be construed as limitations to the present application.

In the description of the embodiments of the present application, unless otherwise clearly stipulated and limited, the technical terms such as "installation", "linkage", "connection" and "fixation" should be understood in a broad sense, for example, the technical term "connection" may be a fixed connection, a detachable connection, or integration; it may also be a mechanical connection, or an electrical connection; it may further be a direct connection, an indirect connection through an intermediary, an internal communication of two components or an interaction between two components. For those of ordinary skill in the art, the specific meanings of the above terms in the embodiments of the present application can be understood according to specific situations.

Cells in a lithium-ion battery need to be aged after being subjected to formation, i.e., being charged and discharged for the first time after an electrolyte is injected. The purposes of ageing are mainly as follows:
1, once the cells are placed at a high temperature or a normal temperature for a period of time, the full infiltration of pole pieces in electrolyte can be ensured, which is beneficial to the performance stabilization of the cells;
2, after the cells are subjected to pre-formation, a certain amount of solid electrolyte interphase (SEI) will be formed on a graphite cathode inside the cell, but the interphase has a tight structure and small pores, thus, ageing the cell at a high temperature is conducive to reconstituting the structure of the SEI to form a loose and porous interphase;
3, the voltage of the cell subjected to formation is in an unstable stage, and active substances in anode and cathode materials, after being aged, can accelerate some side effects such as gas production, electrolyte decomposition, metal impurities precipitation, so that the electrochemical performance of the lithium cell is quickly stable;
4, unqualified cells with serious self-discharge are eliminated, which facilitates to screen cells with high consistency.

A main purpose is the screening of internal micro-short-circuited cells by means of an ageing process. An open circuit voltage will drop during a cell storage process, but a magnitude will not be very large. If the open circuit voltage drops too fast or the magnitude is too large, then it is an abnormal phenomenon.

Self-discharge sorting is an ultimate goal of a cell ageing process, and cell self-discharge can be divided into physical self-discharge and chemical self-discharge according to different reaction types. In consideration of the impact of self-discharge on cells, self-discharge may be divided into two types: self-discharge in which the loss of capacity can be reversibly compensated and self-discharge in which the capacity is lost permanently.

Generally speaking, the energy loss caused by physical self-discharge is reversible, while the energy loss caused by chemical self-discharge is basically irreversible. Self-discharge of the cell is derived from two aspects:
(1) self-discharge caused by a chemical system itself, which is mainly caused by side reactions inside the cell, specifically including changes of surface film layers of anode and cathode materials; potential changes caused by thermodynamic instability of electrodes; and the dissolution and precipitation of metal foreign matter impurities; and
(2) self-discharge of the cell caused by a micro-short circuit inside the cell caused by a separator, an anode and a cathode.

When a lithium-ion cell is aged, the change of a K value is the formation and stabilization process of the SEI on the surface of an electrode material. If a voltage drop is too large, it means that there is a micro-short circuit inside, so it can be determined that the cell is a substandard product. The K value is a physical quantity used to describe a self-discharge rate of a cell, and a calculation method of the K value is implemented by dividing an open circuit voltage difference between two tests by a time interval Δt between two voltage tests, where a formula is: K=(OCV2-OCV1)/Δt.

In an existing test method, a battery is charged at different charge rates to different states of charge (SOC), such as 15-35%, 50-55%, 90-100%, to test an open-circuit cell, the cell is stood at room temperature for 1-15 days as a test cycle, an open circuit voltage is tested several times (1-10 times), and a voltage drop is calculated by using a formula ΔV=OCVn-OCVn-1 (OCVn is the open circuit voltage of the n-th test, and OCVn-1 is the open circuit voltage of the n-1-th test), and finally, self-discharge grouping is performed on the cell by using ΔV.

Although the existing test method can be applied to the self-discharge test and sorting of lithium iron phosphate ion batteries, for a low-potential cell, such as a cell of a LFP system, this method has the following defects:
1, the potential of the cell of the LFP system is low, 3.65V specifically, which is not conducive to the precipitation of metal impurities; and the entire test process is performed at room temperature, so the required test time is long, which affects the operation efficiency of selection of unqualified products by self-discharge; and
2, the low potential of the cell will also result in a small dechemical self-discharge capacity and tested self-discharge mainly includes chemical self-discharge, so the accuracy is low, which affects the operation effect of selection of unqualified products by self-discharge.

For this reason, in the present application, the self-discharge sorting of low-potential cells is optimized starting with the ageing process, and a high-potential cell is utilized to continuously charge a plurality of low-potential cells during the ageing stage, so that the low-potential cells can be allowed to achieve the purposes of high-temperature and high-potential dechemical self-discharge and metal precipitation acceleration.

An inventive idea of the cell charging and discharging tray provided by the present application is derived from a cell ageing method.

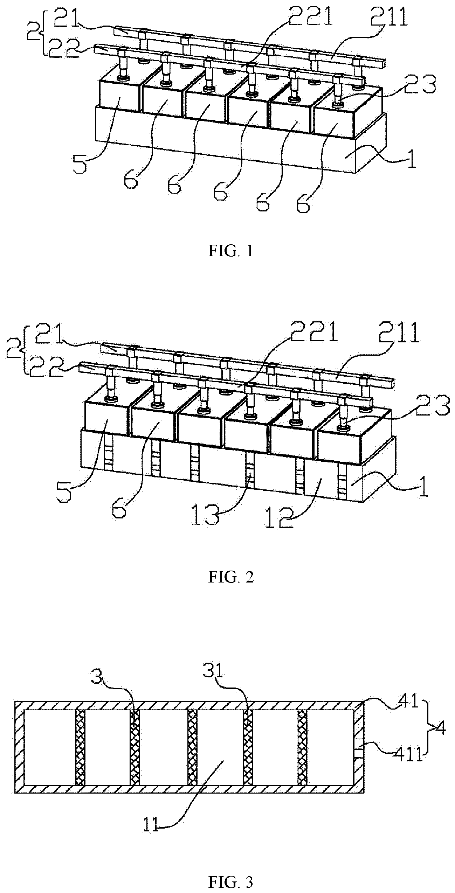

Referring to FIGS. 1-3, FIG. 1 is a structural schematic diagram of a cell charging and discharging tray according to the present application; FIG. 2 is another structural schematic diagram of the cell charging and discharging tray according to the present application; and FIG. 3 is a partial structural schematic diagram of the cell charging and discharging tray according to the present application.

According to some embodiments of the present application, the present application provides a cell charging and discharging tray adapted for simultaneously ageing one type-A cell 5 and a plurality of type-B cells 6. A potential of the type-A cell 5 is higher than that of each of the B-type cell 6, and the tray includes: a base component 1 and a conductive component 2, the base component 1 being separated from the conductive component 2. Where, the base component is insulating, and configured to accommodate the type-A cell 5 and the type-B cells 6, and the conductive component 2 is configured to realize sequential parallel connection of the type-A cell 5 and the type-B cells 6.

Referring to FIG. 1, FIG. 1 is a structural schematic diagram of a cell charging and discharging tray according to the present application.

In some embodiments of the present application, cells to be aged include one type-A cell 5 and four B-type cells 6 arranged together in sequence, and the cells are cuboids of the same size, a positive pole and a negative pole are provided on the upper surface of each cell, the type-A cell 5 is, for example, a cell of an NCM system, which has been charged to a certain SOC, such as ≥ 70%; and the B-type cell 6 is, for example, a cell of an LFP system, which has been fully charged.

In some embodiments of the present application, the cell charging and discharging tray includes a base component 1 and a conductive component 2, where the base component 1 and the conductive component 2 are separated from each other.

The base component 1 is a bottom plate 11, and the type-A cell 5 and the four B-type cells 6 are accommodated on the upper surface of the base component 1; in order to avoid short circuits caused by accidental contacts of the base component 1 with the conductive component 2, the base component 1 is preferably prepared and molded by using an insulating material; in order to match the size of the cells after being arranged together, the bottom plate 11 is set to be square in some embodiments of the present application; and in order to prevent the cells from falling during handling, in some embodiments of the present application, the bottom plate 11 11 extends upward along the periphery of a bottom surface to form side walls 12.

The conductive component 2 includes a first conductive component 21 and a second conductive component 22. The first conductive component 21 connects positive poles of the type-A cell 5 and the four B-type cells 6 sequentially; and the second conductive component 22 connects negative poles of the type-A cell 5 and the four B-type cells 6 sequentially in the same order, so that sequential parallel connection of the type-A cell 5 and the four type-B cells 6 is achieved.

Where, the first conductive component 21 includes a first metal strip 211 and a plurality of probes 23 arranged on the lower surface of the first metal strip 211; one end of each probe 23 is fixed on the positive pole of the corresponding cell and the other end thereof is fixed on the lower surface of the first metal strip 211. The second conductive component 22 includes a second metal strip 221 and a plurality of probes 23 arranged on the lower surface of the second metal strip 221; one end of each probe 23 is fixed on the negative pole of the corresponding cell and the other end thereof is fixed on the lower surface of the second metal strip 221. The numbers of the probes 23 arranged under the two metal strips are the same, and the probe 23 has relatively low requirements on a material, and the material is only required to be chargeable and dischargeable.

In some embodiments of the present application, a method of using the cell charging and discharging tray (that is, a method of ageing cells by using the cell charging and discharging tray disclosed in some embodiments of the present application) is as follows:
(1) positive poles and negative poles of a type-A cell 5 and B-type cells 6 are put into the base component 1 in an upward manner, where the B-type cells 6 are arranged together, and the type-A cell 5 is located on one side, specifically either on the left or right side;
(2) probes 23 of a first metal strip 211 are fixed on the positive poles of the cells, where one probe 23 is fixed on one positive pole;
(3) probes 23 of a second metal strip 221 are fixed on the negative poles of the cells, where one probe 23 is fixed on one negative pole, so that the type-A cell 5 and the B-type cells 6 are sequentially connected in parallel;
(4) a base component 1 is moved to a high-temperature ageing room, standing is performed for 0-7 days, ageing is performed under temperature control at 25-80°C, and after the time of standing is over, the tray is put into a room-temperature standing room;
(5) after cooling, the first metal strip 211 and the second metal strip 221 are removed, and the voltage OCV1 of each cell is tested;
(6) standing is performed at room temperature for 12 hours to 30 days, and then the voltage OCV2 of each cell is tested; and
(7) according to a calculation formula of cell self-discharge K=(OCV2-OCV1)/time of standing at room temperature, by comparing with customer demands, the cells that do not satisfy self-discharge are selected.

It should be noted that, in the above steps of testing the voltage OCV1, testing the voltage OCV2, comparing with customer demands, and selecting cells that do not satisfy self-discharge, the type-A cell 5 is taken as a work object, which is one of differences from existing methods of ageing by fixing high-potential cells.

In some embodiments of the present application, the base component 1 and the conductive component 2 are designed separately, so that the ageing of the high-potential type-A cell 5 is completed after each low-potential B-type cell 6 is aged, and the service life of the type-A cell 5 is not affected, thus, the type-A cell 5 can also be self-discharged to select bad products and then achieve shipment, which effectively saves the cost of ageing; compared with a mode of fixing a high-potential cell to charge low-potential cells, the damage of the high-potential cell due to cyclic ageing is avoided, thereby reducing the cost of manufacturing; and the cell charging and discharging tray of the present application is very simple, which further reduces the cost of ageing.

Referring to FIG. 2, FIG. 2 is another structural schematic diagram of the cell charging and discharging tray according to the present application.

In some embodiments of the present application, in order to facilitate the handling of the base component 1 during an ageing process, in some embodiments provided by the present application, gripping portions 13 are also provided on the base component 1. For example, the gripping portions 13 can be formed on two opposite side walls 12 in a partially sunken manner; and the gripping portions 13 can also be formed on the tops of the two opposite side walls 12 along a surface parallel to the bottom surface of the bottom plate 11 by extending in an opposite direction. These two modes can be achieved by using an integrated molding processing method after a corresponding abrasive tool is designed, so the implementation is very simple.

Referring to FIG. 3, FIG. 3 is a partial structural schematic diagram of the cell charging and discharging tray according to the present application.

During the ageing process, in order to prevent the occurrence of safety accidents caused by fire breaking out due to the collision of cells, in some embodiments provided by the present application, insulating separation components 3 are inserted between the cells. The insulating separation components 3 may be separated baffles 31, the number of the baffle 31 is the same as that of the B-type cell 6; the insulating separation components 3 may also be arranged on the base component 1 in parallel, and the mode of arranging the insulating separation components 3 on the base component 1 may be a mode of integrated molding, and has the advantages that: on the one hand, the insulating separation of the cells is realized, and on the other hand, when a spacing distance between the baffles 31 matches the size of the cell, a poor contact between each probe 23 and a positive/negative pole of the corresponding cell caused by shaking during handling can also be avoided, however, the versatility of the cell charging and discharging tray after being subjected to integrated molding becomes worse due to the requirement of the size of the cell.

Referring to FIG. 3, FIG. 3 is a partial structural schematic diagram of the cell charging and discharging tray according to the present application.

In order to solve the poor contact between each probe 23 and the positive/negative poles of the corresponding cell due to shaking during the handling process, a fastening component 4 is added in some embodiments of the present application. The fastening component 4 after encircling the cells can achieve the integrated fastening of the cells, the fastening component 4 may be a flexible belt-shaped hoop 41, and an opening-closing connection portion 411 capable of being opened and closed is arranged at an opening of the hoop 411. A method of using the hoop 41 includes: after the positive and negative poles of the type-A cell 5 and the B-type cells 6 are put in the base component 1 in an upward manner, the hoop 41 in an open state encircles the cells, then the opening-closing connection portion 411 of the hoop 41 is fastened, and after the cells are cooled at room temperature, the opening-closing connection portion 411 of the hoop 41 is opened, at this point, the hoop 41 can be removed.

In some embodiments of the present application, the probes 23 can be arranged on the lower surface of the metal strip in a manner of integrated molding; a plurality of grooves with an internal thread can also be arranged on the lower surface of each metal strip, and an external thread is provided at the upper end of each probe 23, so that the threaded connection of each probe 23 and its corresponding metal strip is achieved. The former manner of setting the probes 23 can reduce the processing cost, but will lead to poor versatility of the cell charging and discharging tray due to the requirement of the size of the cells; and the latter manner of setting the probes 23 is more complicated in processing, and a distance between the probes 23 may need to be adjusted during each ageing, which will affect the working efficiency. However, when the number of the grooves on the lower surface of each metal strip is greater than the number of the probe 23 on the metal strip, an effect that the cell charging and discharging tray is adapted for ageing cells with different sizes can be achieved.

In order to achieve the versatility of the cell charging and discharging tray, in the conductive component 2, the metal strips disclosed in this embodiment can also be replaced with flexible conductive wires. Specifically, the first conductive component 21 includes a first main flexible conductive wire and X branch flexible conductive wires, where one end of each of the X branch flexible conductive wires are connected to the first main flexible conductive wire at intervals, and the other ends of the X branch flexible conductive wires are connected to a conductive clip; the second conductive component 22 includes a second main flexible conductive wire and Y branch flexible conductive wires, where one end of each of the Y branch flexible conductive wires are connected to the second main flexible conductive wire at intervals, and the other ends of the Y branch flexible conductive wires are connected to a conductive clip; both X and Y are natural numbers greater than or equal to 2. The disadvantage of such solution is that the installation and removal of the conductive clips and the positive/negative poles need to be completed one by one, which affects the work efficiency. When the above-mentioned solution of the metal strips is adopted, the conductive component 2 is a rigid component, and the installation and removal of the conductive clips and the positive/negative poles can be completed in one operation, which can greatly improve the working efficiency.

In some embodiments of the present application, the beneficial effects achieved by the cell charging and discharging tray are as follows:
(1) the base component and the conductive component of the cell charging and discharging tray are designed separately, so that the ageing of a high-potential cell is completed after low-potential cells are aged, and the service life of the high-potential cell is not affected, so that shipment may be performed after self-discharge for selecting bad products is completed, which is conducive to improving the manufacturing efficiency;
(2) compared with a mode of fixing a high-potential cell to charge low-potential cells, the damage of the high-potential cell due to cyclic ageing is avoided, which is conducive to reducing the cost of manufacturing; and
(3) the cell charging and discharging tray of the present application has a simple structure, which is conducive to reducing the cost of the cell ageing device.

In some embodiments of the present application, the beneficial effects achieved by the cell ageing device with the cell charging and discharging tray in any one of the above-mentioned embodiments are as follows:
(1) the high-potential cells are connected in parallel with the low-potential cells, so that the high-potential cells continuously charge the low-potential cells, thus solving the problem that when a cell is aged, if the cell has a low potential and an unstable voltage, the purposes of effectively performing high-temperature and high-potential dechemical self-discharge and metal precipitation acceleration cannot be achieved;
(2) during ageing, the potential of the low-potential cell is raised and the voltage is stable, so that the purposes of high-temperature and high-potential dechemical self-discharge and metal precipitation acceleration can be effectively achieved;
(3) after the low-potential cells are aged, the ageing of the high-potential cells is also completed, so shipment may be performed after self-discharge for selecting bad products is completed, and the service life of the cells is not affected, thereby effectively saving the cost of equipment; and
(4) compared with a mode of fixing a high-potential cell to charge low-potential cells, in which the high-potential cell is in a high-temperature state for a long time and thus is easy to be damaged, the high-potential cell of the present application can achieve shipment, thereby reducing the cost of manufacturing.

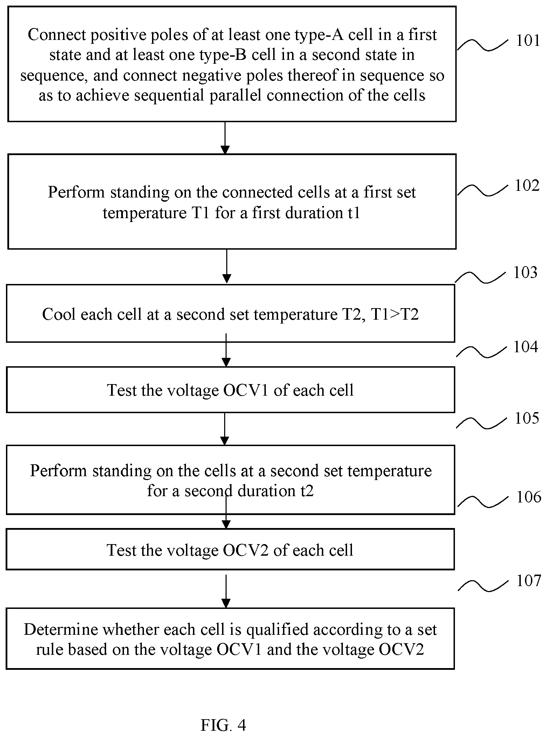

Referring to FIG. 4, FIG. 4 is a flow chart of a cell ageing method according to the present application.

In some embodiments of the present application, the present application provides a cell ageing device including a tray which is the cell charging and discharging tray in any one of the above embodiments.

In some embodiments of the present application, the present application also provides a cell ageing method performing ageing by using the cell ageing device in any one of the above embodiments, the cell ageing method including the following steps:
step 101: positive poles of at least one type-A cell 5 in a first state and at least one type-B cell 6 in a second state are connected through a first conductive component 21 in sequence, and negative poles thereof are connected through a second conductive component 22 in sequence, where the potential of the type-A cell is higher than that of each of the type-B cells;
step 102: standing is performed on the connected cells at a first set temperature T1 for a first duration t1;
step 103: each cell is cooled at a second set temperature T2, where T1 is greater than T2;
step 104: a voltage OCV1 of each cell is tested;
step 105: standing is performed on the cells at the second set temperature for a second duration t2;
step 106: a voltage OCV2 of each cell is tested; and
step 107: based on the voltage OCV1 and the voltage OCV2, whether each cell is qualified is determined according to a set rule.

In the technical solutions of the embodiments of the present application, via step 101, the parallel connection of the type-A cell 5 and the B-type cells 6 in sequence can be realized; and the potential of the type-A cell 5 needs to be higher than that of each B-type cell 6, so that the purpose of charging the type-B cells 6 with the type-A cell 5 all the time during the ageing process may be achieved.

In the technical solutions of the embodiments of the present application, in order to facilitate the pick-and-place of the cells that have been connected during the ageing process, before the cells are connected, the type-A cell 5 and the B-type cells 6 can be placed on the base component 1 in sequence, or, the type-A cells 5 and the B-type cells 6 are arranged in sequence and then encircled by the fastening component 4 to realize integrated fastening. The base component 1 or the fastening component 4 is generally made of insulating materials to avoid short circuits of the cells caused by being in accidental contact with the first conductive component 21 or the second conductive component 21. In addition, the cells can be separated by the baffles 31 to prevent the occurrence of safety accidents caused by fire breaking out due to the collision of the cells.

In the technical solutions of the embodiments of the present application, the type-B cell 6 is generally a cell of an LFP system, and the cell of this system is a cathode lithium supplement material, so the cell also has a capability of high potential, but the content is small, and the retention rate of the high potential is low, thus, the high potential may be kept only by continuous charging. In order to avoid the energy shortage of the type-A cell 5 to charge the type-B cells 6 during the ageing process, the type-B cells 6 can be charged to a fully charged state before being aged.

In the technical solutions of embodiments of the present application, the type-A cell is configured to charge the type-B cells, so the potential of the type-A cell needs to be higher than that of each type-B cell. A cell with a highest working voltage greater than or equal to 4.05V is called a cell of a high-potential system, which can be used as the type-A cell of some embodiments of the present application; the cell is generally a cell of a NCM system, and also may be a cell of a lithium cobalt oxide, ternary, or high nickel system or the like; and the potential of the type-A cell may be kept at greater than or equal to 3.85V after the type-A cell is charged until SOC is greater than or equal to 70%.

It should be noted that a voltage of a process of testing a K value of the cell of the NCM system is greater than or equal to 3.85V, and a stable potential of the cell of the LFP system is 3.4-3.5V, so the LFP system needs to be kept in a fully charged state during a K value test process.

Each type-B cell 6 is generally a cell of an LFP system, and the cell of this system is a cathode lithium supplement material, so the cell also has a capability of high potential, but the content is small, and the retention rate of the high potential is low, so the high potential may be kept only by continuous charging. In order to avoid the energy shortage of the type-A cell 5 to charge the type-B cells 6 during the ageing process, the type-B cells 6 can be charged to a fully charged state before being aged.

From the perspectives of ageing cost, efficiency and effect, specific process parameters are selected as follows: the first set temperature T1 is 25-80°C or 35-80°C, the second set temperature T2 is normal temperature, and the first duration t1 is 0.7 day or 0-5 day, and the second duration t2 is 12 hours-30 days.

A rule for selecting bad products in the above method can be designed according to customer needs. It is preferable to calculate a voltage drop per unit time of each cell according to a formula K=(OCV2-OCV1)/t2, then to convert the voltage drop per unit time into a K value specification according to monthly self-discharge requirements, and to determine that a cell having a voltage drop greater than the K value specification is unqualified and a cell having a voltage drop less than or equal to the K value specification is qualified. For customers who have high quality control requirements, the rule may be tightened for selection, such as raising the K value specification by a certain percentage.

In some embodiments of the present application, the first state refers to that a state of charge is greater than or equal to 70% and a holding potential is greater than or equal to 3.85V.

In some embodiments of the present application, the second state refers to a state of being fully charged with lithium.

In some embodiments of the present application, a maximum working voltage of each type-A cell is greater than or equal to 4.05V.

In some embodiments of the present application, the type-A cell 5 is a cell of a NCM system, lithium cobaltate, a ternary system or a high-nickel system.

In some embodiments of the present application, each type-B cell 6 is a cell of a LFP system.

In some embodiments of the present application, the first set temperature T1 is 25-80°C or 35-80°C.

In some embodiments of the present application, the second set temperature T2 is normal temperature.

In some embodiments of the present application, the first duration t1 is 0-7 days or 0-5 days.

In some embodiments of the present application, the second duration t2 is 12 hours to 30 days.

In some embodiments of the present application, the set rule is to calculate a voltage drop per unit time of each cell according to a formula K=(OCV2-OCV1)/t2, then to convert the voltage drop per unit time into a K value specification according to monthly self-discharge requirements, and to determine that a cell having a voltage drop greater than the K value specification is unqualified and a cell having a voltage drop less than or equal to the K value specification is qualified.

In some embodiments of the present application, before step 101, the type-A cell 5 and the type-B cells 6 are sequentially placed on the base component 1, or, the type-A cell 5 and all kinds of cells 6 are arranged in sequence and then encircled by the fastening component 4 to achieve integrated fastening.

In some embodiments of the present application, the base component 1 and the fastening component 4 have insulating properties.

In some embodiments of the present application, before step 101, a step of placing separation components 3 between the cells is added.

In some embodiments of the present application, before or after step 103, the first conductive component 21 and the second conductive component 22 are removed.

In some embodiments of the present application, the beneficial effects achieved by using the cell ageing method are as follows:
when a cell is aged, if the cell has a low potential and an unstable voltage, the purposes of effectively performing high-temperature and high-potential dechemical self-discharge and metal precipitation acceleration cannot be achieved. Therefore, in the above cell ageing method, a high-potential cell is connected in parallel with low-potential cells, so that the high-potential cell continuously charges the low-potential cells, in such a way that the potential of the low-potential cell is raised and the voltage is stable, thus, the purposes of effectively performing high-temperature and high-potential dechemical self-discharge and metal precipitation acceleration may be achieved.

It should be understood that the embodiments disclosed in the present application are not limited to the particular processing steps or materials disclosed herein, but shall extend to equivalent substitutes of such features as would be understood by those of ordinary skill in related arts. It is also to be understood that the terms used herein are for the purpose of describing particular embodiments only and are not meant to be restrictive.

Reference to "embodiment" in the Specification means that particular features or characteristics described in connection with the embodiments are included in at least one embodiment of the present application. Thus, the phrase or "embodiment" in various places throughout the Specification are not necessarily all referring to a same embodiment.

Furthermore, the described features or characteristics may be combined into one or more embodiments in any other suitable manner. In the above description, some specific details, such as thicknesses, quantities and the like, are provided to provide a thorough understanding of the embodiments of the present application. However, it will be appreciated by those skilled in related arts that the present application may be implemented without one or more of the specific details described above, or may also be implemented using other methods, components, materials, etc.

## Claims

1. A cell charging and discharging tray adapted for simultaneously ageing one type-A cell (5) and a plurality of type-B cells (6), a potential of the type-A cell (5) being higher than that of type-B cell (6), and the tray comprising:
an insulating base component (1) for accommodating the type-A cell (5) and the type-B cells; and
a conductive component (2) for realizing sequential parallel connection of the type-A cell (5) and the type-B cells (6);
where the base component (1) is separated from the conductive component (2).

2. The cell charging and discharging tray according to claim 1, wherein the base component (1) is a bottom plate (11) extending upwards along the periphery of a bottom surface to form side walls (12).

3. The cell charging and discharging tray according to claim 2, wherein gripping portions (13) are formed on two opposite side walls (12) in a partially sunken manner; or, gripping portions (13) are formed on the tops of the two opposite side walls (12) along a surface parallel to the bottom surface of the bottom plate (11) by extending in an opposite direction.

4. The cell charging and discharging tray according to any one of claims 1-3, wherein the tray further comprises a plurality of insulating separation components (3) for separating the cells, the separation components (3) are a plurality of baffles (31) separated from each other, and the baffles (31) are arranged in parallel on the base component (1).

5. The cell charging and discharging tray according to any one of claims 1-4, wherein the tray further includes a fastening component (4) for encircling the cells to realize integrated fastening of the cells.

6. The cell charging and discharging tray according to claim 5, wherein the fastening component (4) is a flexible belt-shaped hoop (41), and an opening-closing connection portion (411) capable of being opened and closed is arranged at an opening of the hoop.

7. The cell charging and discharging tray according to any one of claims 1-6, wherein the conductive component (2) comprises a first conductive component (21) for realizing sequential connection of positive poles of the type-A cell (5) and the type-B cells (6), and a second conductive component (22) for realizing sequential connection of negative poles of the type-A cell (5) and the type-B cells (6) in the same order.

8. The cell charging and discharging tray according to claim 7, wherein the first conductive component (21) comprises a first metal strip (211) and X probes (23) arranged at intervals on a lower surface of the first metal strip; the second conductive component (22) comprises a second metal strip (221) and Y probes (23) arranged at intervals on a lower surface of the second metal strip; wherein both X and Y are natural numbers greater than or equal to 2.

9. The cell charging and discharging tray according to claim 8, wherein a spacing distance between the probes (23) arranged on the first metal strip (211) is equal to a spacing distance between the probes (23) arranged on the second metal strip (221).

10. The cell charging and discharging tray according to claim 8 or 9, wherein a plurality of grooves with an internal thread are respectively provided at intervals on the lower surfaces of the first metal strip (211) and the second metal strip (221), and an external thread for realizing threaded connection with the grooves is provided at an upper end of each of the probes (23).

11. The cell charging and discharging tray according to claim 10, wherein the number of the grooves with an internal thread arranged at intervals on the lower surface of the first metal strip (211) is greater than X; and the number of the grooves with an internal thread arranged at intervals on the lower surface of the second metal strip (221) is greater than Y.

12. The cell charging and discharging tray according to any one of claims 8-11, wherein X is equal to Y.

13. The cell charging and discharging tray according to any one of claims 7-12, wherein the first conductive component (21) comprises a first main flexible conductive wire and X branch flexible conductive wires, where one end of each of the X branch flexible conductive wires are connected to the first main flexible conductive wire at intervals, and the other ends of the X branch flexible conductive wires are connected to a conductive clip; the second conductive component (22) comprises a second main flexible conductive wire and Y branch flexible conductive wires, wherein one end of each of the Y branch flexible conductive wires are connected to the second main flexible conductive wire at intervals, and the other ends of the Y branch flexible conductive wires are connected to a conductive clip; and both X and Y are natural numbers greater than or equal to 2.

14. A cell ageing device, comprising a tray, wherein the tray is the cell charging and discharging tray according to any one of claims 1-13.

15. A cell ageing method, performing ageing by using the cell ageing device according to claim 14, the cell ageing method comprising the following steps:
step 1: connecting positive poles of at least one type-A cell (5) in a first state and at least one type-B cell (6) in a second state through a first conductive component (21) in sequence, and connecting negative poles thereof through a second conductive component (22) in sequence, wherein a potential of the type-A cell (5) is higher than that of each of the type-B cells (6);
step 2: performing standing on the connected cells at a first set temperature T1 for a first duration t1;
step 3: cooling each cell at a second set temperature T2, wherein T1 is greater than T2;
step 4: testing a voltage OCV1 of each cell;
step 5: performing standing the cells at the second set temperature for a second duration t2;
step 6: testing a voltage OCV2 of each cell; and
step 7: based on the voltage OCV1 and the voltage OCV2, determining whether each cell is qualified according to a set rule.

16. The cell ageing method according to claim 15, wherein the first state refers to that a state of charge is greater than or equal to 70% and a holding potential is greater than or equal to 3.85V, and the second state refers to a state of being fully charged with lithium.

17. The cell ageing method according to claim 15 or 16, wherein a maximum working voltage of the at least one type-A cell (5) is greater than or equal to 4.05V.

18. The cell ageing method according to any one of claims 15-17, wherein the first set temperature T1 is 25-80°C or 35-80°C, and the second set temperature T2 is normal temperature.

19. The cell ageing method according to any one of claims 15-18, wherein the first duration t1 is 0-7 days or 0-5 days, and the second duration t2 is 12 hours-30 days.

20. The cell ageing method according to any one of claims 15-19, wherein the set rule is to calculate a voltage drop per unit time of each cell according to a formula K=(OCV2-OCV1)/t2, then to convert the voltage drop per unit time into a K value specification according to monthly self-discharge requirements, and to determine that a cell having a voltage drop greater than the K value specification is unqualified and a cell having a voltage drop less than or equal to the K value specification is qualified.
